Europäisches Patentamt

European Patent Office

Office européen des brevets

(11) Numéro de publication : **0 323 924 B1**

(12) **FASCICULE DE BREVET EUROPEEN**

(45) Date de publication du fascicule du brevet :
**11.11.92 Bulletin 92/46**

(51) Int. Cl.⁵ : **G11C 27/04, G11C 19/28**

(21) Numéro de dépôt : **89400008.2**

(22) Date de dépôt : **03.01.89**

(54) **Procédé et circuit de lecture à faible bruit pour matrice photosensible à transfert de ligne.**

(30) Priorité : **05.01.88 FR 8800027**

(43) Date de publication de la demande :
**12.07.89 Bulletin 89/28**

(45) Mention de la délivrance du brevet :
**11.11.92 Bulletin 92/46**

(84) Etats contractants désignés :
**DE FR GB NL**

(56) Documents cités :
**US-A- 3 963 942**

(56) Documents cités :
**PROCEEDINGS OF 5TH INTERNATIONAL CONFERENCE ON CHARGE-COUPLED DEVICES, septembre 1979, pages 33-39, J. MAVOR, University ofEdinburgh; S. IWASA et al.: "Mosaic CCD multiplexer for pyroelectric hybrid focal plane"**
**RCA REVIEW, vol. 40, no. 3, septembre 1979, pages 241-277, Princeton, US; W.F. KOSONOCKY et al.: "Low-loss charge-coupleddevice"**

(73) Titulaire : **THOMSON-CSF**
**51, Esplanade du Général de Gaulle**
**F-92800 Puteaux (FR)**

(72) Inventeur : **Berger, Jean-Luc**
**THOMSON-CSF SCPI**
**F-92045 PARIS LA DEFENSE CEDEX 67 (FR)**
Inventeur : **Arques, Marc**
**THOMSON-CSF SCPI**
**F-92045 PARIS LA DEFENSE CEDEX 67 (FR)**

(74) Mandataire : **Guérin, Michel et al**
**THOMSON-CSF SCPI**
**F-92045 PARIS LA DEFENSE CEDEX 67 (FR)**

## Description

L'invention concerne les matrices photosensibles à transfert de ligne, c'est-à-dire des matrices d'éléments photosensibles agencés en réseau de lignes et de colonnes, dans lesquelles chaque ligne d'éléments photosensibles peut être adressée pour déverser sur un conducteur de colonne d'une colonne déterminée de la matrice les charges générées par l'élément photosensible situé au carrefour de cette ligne et cette colonne. Les charges ainsi déversées sont appliquées à une case d'un registre à décalage à transfert de charges dont les autres cases reçoivent les charges déversées par les autres colonnes de la matrice.

La matrice fonctionne en deux phases se renouvelant périodiquement: une première phase pendant laquelle les éléments photosensibles produisent et stockent des charges sous l'effet d'un éclairement, tandis que simultanément le registre à décalage décale vers sa sortie les charges qu'il a reçues à la période précédente; et une deuxième phase pendant laquelle le registre reçoit des colonnes les charges accumulées par les éléments photosensibles pendant la première phase.

L'invention s'intéresse spécialement au circuit de lecture de cette matrice, c'est-à-dire au circuit par lequel les charges sont transférées des colonnes vers le registre au cours de la deuxième phase de chaque période.

Un des problèmes que l'on rencontre avec ce type de matrice est celui du bruit qui est introduit pendant le transfert des charges à travers le circuit de lecture entre les colonnes de la matrice et le registre à décalage. Ce bruit est en général d'origine thermique; il est constitué par une certaine quantité de charges indésirables, non provoquées par l'éclairement des éléments photosensibles mais transférées en même temps que les charges générées par l'éclairement.

Or le bruit est d'autant plus important que les capacités mises en oeuvre sont plus élevées. En particulier, compte-tenu de la structure matricielle du dispositif, la capacité globale d'une colonne d'éléments photosensibles est la somme des capacités des points photosensibles individuels raccordés à cette colonne. A titre d'exemple, la capacité individuelle d'un point photosensible peut être typiquement de 1 picofarad et celle de la colonne de 2 000 picofarads, pour une matrice de grand format de 2000 lignes à base de silicium amorphe.

On peut considérer que le bruit thermique Bth introduit lorsqu'il y a une capacité de valeur C est sensiblement égal à:

$$Bth = (kTC/q^2)^{1/2}$$

où K est la constante de Boltzmann, T la température en degrés Kelvin, et q la charge de l'électron.

Concrètement, pour une capacité de 1 picofarad, le bruit est de 400 électrons qui viennent parasiter le signal utile transféré sur la colonne. Pour une capacité de colonne de 2000 picofarads, le bruit est de 18000 électrons. C'est une valeur énorme si l'on considère que l'on cherche à détecter un signal correspondant à quelques milliers d'électrons pour de faibles éclairements.

Pour réduire le bruit introduit par la capacité de colonne et transféré de la colonne vers le registre à décalage de sortie, on a déjà proposé d'introduire un amplificateur de contre-réaction entre la colonne et une grille de transfert servant au déversement périodique des charges de la colonne vers le registre à décalage. L'amplificateur a un gain négatif -G. Ainsi, une fluctuation de potentiel positive sur la colonne, correspondant à une charge de bruit transférée en excès, se traduit par une réduction du potentiel appliqué sur la grille de transfert, ce qui fait décroître le courant d'injection et provoque en conséquence le transfert d'une charge plus faible. L'amplificateur introduit donc un effet de compensation qui limite la charge de bruit injectée. On peut considérer alors que tout se passe comme si le transfert sous la grille provenait d'une colonne de capacité C/G au lieu de C. Le bruit thermique introduit est donc divisé par $G^{1/2}$.

On peut gagner beaucoup de cette manière sur le bruit thermique et donc sur la dynamique du signal utile qu'on peut obtenir du côté des bas niveaux d'éclairement.

Malheureusement l'amplificateur de gain -G qu'on a rajouté dans le circuit introduit lui-même du bruit dans les charges transférées.

L'invention propose une nouvelle solution pour réduire le bruit introduit par le transfert de charges de la matrice vers le registre à décalage de sortie.

Selon l'invention, on propose un procédé de lecture tel que défini dans la revendication 1, consistant en résumé à transférer N fois (N entier supérieur ou égal à 2), de la colonne vers une zone de stockage intermédiaire, la quantité de charges qu'on veut lire, à la dupliquer à chaque fois, à restituer à chaque fois la charge originale vers la colonne d'entrée, à se servir de la charge dupliquée pour établir une quantité de charges proportionnelle à la somme des charges transférées à chaque fois, et à transférer finalement vers le registre de sortie une quantité de charges proportionnelle à la somme des charges transférées vers la zone intermédiaire.

Par cet artifice, on s'aperçoit que l'on réduit le bruit transféré dans la mesure où les bruits introduits lors de chaque transfert sont décorrélés les uns des autres et s'annulent donc partiellement. On peut montrer que le bruit global de ce transfert multiple est divisé par $N^{1/2}$ par rapport au bruit qui serait introduit par un seul transfert.

On notera que l'article "Mosaic CCD multiplexer for pyroelectric hybrid focal plane", de S. Iwasa et autres, paru dans "Proceedings of 5th international conference on charge - coupled devices", septembre 1979, pages 33-39, mentionne un transfert multiple de la charge à lire, mais pas d'élaboration de charge réplique à chaque transfert.

Pour mettre en oeuvre ce procédé, la présente invention propose un circuit de lecture de charges connecté à un conducteur d'entrée amenant des charges à lire, ce circuit comportant :

- un moyen pour tranférer du conducteur d'entrée vers une zone de stockage intermédiaire une quantité de charges à lire,
- un moyen pour répéter les opérations de transfert de l'entrée vers la zone intermédiaire, caractérisé en ce qu'il comporte en outre :
- un moyen pour engendrer une quantité de charges (Qs*) qui est la réplique de la charge transférée dans la zone de stockage intermédiaire,
- un moyen pour retransférer vers le conducteur d'entrée la quantité de charges transférée du conducteur d'entrée,
- un moyen pour stocker une charge qui est la somme des charges répliques,
- et un moyen pour transférer vers la sortie une charge proportionnelle à la somme des charges répliques.

On comprend par conséquent qu'au lieu de transférer en une seule fois de la colonne vers le registre la quantité de charges à lire, on transfère cette quantité de charges vers une zone intermédiaire, on la duplique pour la conserver en mémoire, et on la retransfère vers la colonne; on répète l'opération et on ajoute la deuxième charge dupliquée à la première charge dupliquée. Au bout de N transferts, le bruit thermique accumulé dans la somme des charges dupliquées n'est pas multiplié par N par rapport au bruit d'un transfert unique, mais seulement par $N^{1/2}$. Il ne reste qu'à transférer vers la sortie cette somme de charges dupliquées, ou mieux, à transférer vers la sortie une charge qui est la moyenne des charges dupliquées. Le rapport signal sur bruit est alors amélioré dans un rapport $N^{1/2}$.

De préférence, le moyen pour transférer les charges de la colonne vers la zone de stockage intermédiaire est un injecteur de charges comprenant une diode reliée à la colonne, une grille de passage entre la diode et la zone de stockage intermédiaire, une grille de stockage intermédiaire au dessus de la zone de stockage intermédiaire, et un amplificateur à gain négatif ayant une entrée reliée à la colonne et une sortie reliée à la grille de passage. Avec ce type d'injecteur à amplificateur, la durée de transfert d'une charge est fortement accélérée, ce qui permet de mettre en oeuvre l'invention sans que la répétition de N transferts successifs aboutisse à une durée de lecture excessive.

Quant au moyen pour engendrer la quantité de charges réplique, il comprend de préférence d'une part un deuxième injecteur semblable au premier, comprenant une diode, une grille de passage, et une grille de stockage auxiliaire au dessus d'une zone de stockage auxiliaire, et d'autre part un comparateur ayant une première entrée reliée à la grille de stockage intermédiaire, une deuxième entrée reliée à la grille de stockage auxiliaire, et une sortie reliée à la grille de passage du deuxième injecteur, avec un moyen pour appliquer temporairement sur les deux entrées du comparateur une tension de référence commune.

Enfin, le moyen de stockage de la somme des charges répliques comprend de préférence deux grilles de stockage qui sont en principe portées au même potentiel mais qui sont séparées par une grille de blocage. Lorsque la grille de blocage est portée à un potentiel plus élevé que celui des deux grilles, les deux grilles forment une grille unique; lorsque la grille de blocage est portée ensuite à un potentiel bas, chacune des deux grilles stocke une fraction (dans le rapport des surfaces des grilles) des charges accumulées. L'une de ces fractions est appliquée à la sortie du dispositif de lecture et est par exemple déversée dans un registre à transfert de charges de sortie. Cette fraction peut être de $1/N^{ième}$ de la somme des charges répliques.

D'autres caractéristiques et avantages de l'invention apparaîtront à la lecture de la description détaillée qui suit et qui est faite en référence aux dessins annexés dans lesquels:

- la figure 1 représente une vue générale simplifiée d'une matrice photosensible à transfert de ligne;
- la figure 2 représente un schéma de principe d'une structure de circuit de lecture selon l'invention;
- la figure 3 représente l'injecteur de charges permettant de transférer des charges de la colonne à lire vers la grille de stockage intermédiaire; les profils de potentiel correspondants sont également représentés;
- la figure 4 représente le duplicateur de charges permettant d'engendrer la charge réplique Qs*; les profils de potentiel correspondants sont également représentés;

La figure 5 représente la caractéristique de fonctionnement du comparateur du duplicateur de la figure 4;
- la figure 6 représente une vue d'ensemble, en vue de dessus et en coupe d'un mode de réalisation préférentiel de l'invention; les profils de potentiel correspondants sont également représentés;
- la figure 7 représente un perfectionnement permettant d'ajouter à la charge à lire une charge d'entrainement utile lorqu'on veut pouvoir bien lire même des faibles charges.

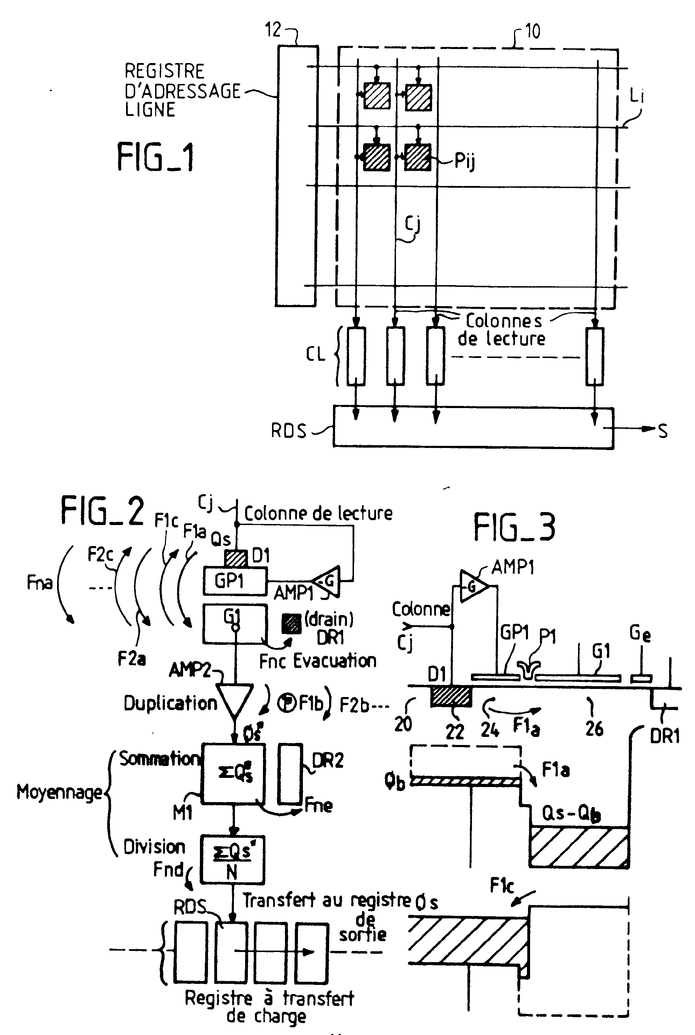

La configuration générale d'une matrice photosensible à transfert de ligne est représentée à la figure 1. Elle comprend un réseau 10 de lignes Li et de colonnes Cj avec, au carrefour de chaque ligne et chaque colonne, un élément de détection photosensible Pij. En réponse à un signal de lecture appliqué à une ligne sélectionnée par un décodeur de lignes 12, chaque point photosensible de cette ligne peut fournir, sur le conducteur de colonne auquel il est rattaché, une quantité de charges proportionnelle à l'intégrale du flux lumineux d'éclairement auquel il a été soumis durant une période de temps d'intégration déterminée.

Les conducteurs de colonne sont reliés à un circuit de lecture CL apte à recevoir les charges de chaque colonne et à les transformer en un signal appliqué à une case respective d'un registre à décalage de sortie RDS; il y a autant de cases du registre que de colonnes de sortie et ces cases sont remplies simultanément par les signaux représentant l'éclairement des différents points photosensibles de celle des lignes du réseau 10 qui vient d'être sélectionnée par le décodeur 12.

Après remplissage du registre à décalage RDS en parallèle, on fait fonctionner le registre en registre à décalage à sortie en série, pour transférer vers la sortie du registre le contenu des cases successives et fournir ainsi en sortie S un signal représentant les éclairements des points successifs de la ligne sélectionnée.

Le circuit de lecture que l'on considère selon la présente invention est le circuit CL intercalé entre les colonnes du réseau et le registre.

Dans la pratique, le registre RDS est un registre à transfert de charges et par conséquent le signal transféré dans les cases du registre sera constitué par une quantité de charges électriques.

Comme on le voit sur la représentation schématique de la figure 1, le circuit de lecture CL est constitué par autant de circuits de lecture individuels identiques CLj qu'il y a de colonnes Cj dans le réseau 10.

On décrira un seul de ces circuits de lecture CLj tel que l'on propose de le réaliser selon la présente invention pour réduire le bruit de transfert entre la colonne et le registre.

La figure 2 représente schématiquement les éléments principaux permettant de mettre en oeuvre le procédé de réduction de bruit proposé ici.

La colonne Cj, sur laquelle arrive une quantité de charges Qs représentant le signal utile à lire, est reliée à un injecteur de charges constitué par une diode D1 et une grille de passage Gp1 destinée à autoriser le passage de charges de la diode D1 vers une région semiconductrice qui sera appelée dans la suite zone de stockage intermédiaire. Cette zone de stockage intermédiaire est située sous une grille G1 qu'on peut appeler aussi grille de stockage intermédiaire.

La grille de stockage intermédiaire est portée à un potentiel suffisamment positif pour permettre une accumulation de charges dans la région qu'elle recouvre.

La grille de passage Gp1 est reliée à la sortie d'un amplificateur AMP1 de gain négatif -G dont l'entrée est reliée à la colonne de lecture Cj et donc à la diode D1.

Grâce à cet injecteur de charges, la charge Qs est transférée sous la grille de stockage intermédiaire G1 avec un bruit thermique relativement limité mais qui comprend quand-même le bruit engendré par l'amplificateur AMP1 lui-même.

On notera qu'on peut prévoir à proximité de la grille G1 une région de drain $D^R$ portée à un potentiel suffisamment positif pour que, en cas d'éclairement trop intense (saturation), l'excès de charges qui ne peut pas être stocké sous la grille G1 soit évacué et ne perturbe pas les autres éléments de circuit. On verra dans les explications qui suivent que cette région de drain DR1 permet aussi l'évacuation des charges stockées à la fin du cycle de lecture, lorsqu'on n'en a plus besoin.

Le cycle de fonctionnement du circuit de lecture se décompose en N étapes comprenant chacune essentiellement trois phases.

La flèche F1a sur la figure 2 représente le trajet des charges pendant la première phase de la première étape du cycle de lecture.

Pendant une deuxième phase, toujours au cours de la première étape, on procède à l'élaboration et au stockage d'une charge Qs∗ qui est la réplique de la charge Qs; cette charge réplique Qs∗ subsistera même lorsque la charge Qs ne sera plus présente sous la grille de stockage intermédiaire G1.

La flèche F1b de la figure 2 représente cette élaboration de la charge Qs∗.

Par charge "réplique" de la charge Qs on entend une charge qui peut être égale à la charge Qs ou dans un rapport connu avec la charge Qs. Dans l'exemple de réalisation pratique préférentiel, il s'agit d'une charge égale à Qs et on parlera dans la suite de "duplication" de la charge Qs pour ce qui concerne l'élaboration de la réplique Qs∗.

La duplication de la charge Qs se fait en utilisant un amplificateur AMP2 selon un mode de fonctionnement que l'on explicitera par la suite.

La charge réplique Qs∗ est stockée dans une région dite "région d'accumulation" sous une grille conductrice M1.

Dans une troisième phase (phase de restitution) de la première étape, représentée par la flèche F1c sur la figure 2, on restitue vers la diode D1 et la colonne Cj la charge Qs qui avait été transférée en sens inverse à la première phase. Cette restitution se fait en portant la grille G1 à un potentiel fortement négatif par rapport au potentiel de la colonne Cj.

On verra dans la suite que la charge aboutissant alors sur la colonne est bien la charge de départ, même si le transfert de la première phase présentait une certaine inefficacité (c'est-à-dire même si un pourcentage de la charge initiale n'avait pu être transféré).

La première étape du cycle de lecture s'achève ainsi.

La deuxième étape est une répétition des phases de la première étape, à savoir d'abord une phase (flèche F2a) de transfert de la colonne vers la grille de stockage intermédiaire G1, puis une phase de duplication (flèche F2b) de la charge transférée, et une phase de restitution de la charge Qs vers la colonne Cj.

Mais la charge "réplique" constituée à la deuxième étape est additionnée, dans la région d'accumulation sous la grille M1, a celle constituée lors de la première étape. En d'autres mots, on déverse dans la région d'accumulation sous la grille M1 la nouvelle charge réplique Qs* sans avoir au préalable évacué la précédente.

Si le nombre d'étapes N est supérieur à 2, on continue alors le processus en répétant à chaque fois les trois phases de transfert, duplication, et restitution.

A la $N^{ième}$ et dernière étape, la seule différence est qu'on supprime la phase de restitution et qu'on la remplace par une phase d'évacuation vers le drain DR1 de la charge Qs dont on n'a plus besoin. La flèche Fnc de la figure 2 représente cette phase d'évacuation vers le drain DR1.

Dans la région d'accumulation sous la grille M1 est alors stockée la somme des charges répliques Qs* résultant des N opérations de transfert et duplication qui viennent d'être exécutées.

C'est cette charge cumulée qui représente globalement N fois la charge initiale Qs, mais affectée d'un bruit de transfert qui n'est pas N fois mais $N^{1/2}$ fois le bruit d'un transfert unique.

On notera que la région d'accumulation doit avoir une capacité de stockage d'autant plus importante que N est plus grand.

Si N est grand, la quantité de charges accumulées à la fin du cycle de lecture d'une ligne de la matrice sera trop importante pour pouvoir être transférée dans le registre de sortie dont les cases sont généralement de petite capacité pour des raisons d'encombrement et de rapidité de fonctionnement.

Par conséquent, on prévoit de préférence de procéder à une opération de division par une quantité prédéterminée de la charge stockée dans la région d'accumulation sous la grille M1 pour ne transférer vers le registre de sortie RDS qu'une fraction (connue) de cette charge.

Dans un exemple de réalisation, on pourra choisir de diviser la charge justement par le nombre N pour aboutir à une charge de même ordre que dans les circuits de lecture n'utilisant pas le principe de la présente invention.

On aboutit alors au transfert dans le registre de sortie de la moyenne des charges dupliquées Qs*.

On comprendra cependant que dans le cas où les charges "répliques" Qs* représentent la charge initiale Qs divisée par un coefficient connu (qui lui aussi peut être N), il ne sera pas forcément nécessaire de procéder à la fin à la division de la charge accumulée sous la grille M1.

Sur la figure 2, les flèches Fnd et Fne représentent respectivement les opérations de transfert vers le registre de sortie de la fraction de la charge accumulée au cours des n étapes précédentes, et d'évacuation vers un drain DR2 du reste de la charge accumulée sous la grille M1 puisqu'il faut repartir de zéro avant de recommencer un cycle de lecture.

On a ainsi décrit l'essentiel du principe de fonctionnement de la présente invention. Les diverses phases du cycle sont exécutées sous le contrôle d'un circuit de séquencement non représenté qui établit sur les différentes grilles de la structure les potentiels nécessaires à chaque phase.

Avant de décrire un mode de réalisation détaillé, on se réfèrera à la figure 3 qui représente d'une part, en coupe transversale, la structure permettant le transfert de la charge Qs de la colonne Cj vers la zone de stockage intermédiaire sous la grille G1, et d'autre part, au dessous de cette coupe, les profils de potentiel dans les différentes régions semiconductrices de la structure.

Dans toutes les explications qui suivent, on considèrera que la structure est formée dans un substrat semiconducteur qui est essentiellement de type p et que les potentiels à appliquer aux grilles pour autoriser un transfert de charges au dessous de cette grille sont des potentiels positifs par rapport au substrat. Le type de substrat et les potentiels pourraient être inversés. De plus, dans les représentations des profils de potentiel, les potentiels positifs vont en croissant vers le bas conformément à une convention maintenant classique dans le domaine des dispositifs à transfert de charge.

Sur la figure 3, on voit la diode D1 dont la cathode est constituée par une région 22 de type N diffusée dans le substrat semiconducteur 20. La cathode est reliée à la colonne Cj et à l'entrée de l'amplificateur AMP1 de gain négatif -G. La sortie de l'amplificateur est reliée à une grille de passage Gp1 surplombant une région de substrat 24 immédiatement adjacente à la région de cathode 22.

Dans une réalisation préférentielle, on prévoit de l'autre côté de la grille Gp1 une grille auxiliaire P1, portée à un potentiel fixe intermédiaire entre les potentiels de la grille de passage Gp1 et de la grille de stockage intermédiaire G1, pour limiter la contre-réaction du potentiel de la grille G1 sur le potentiel présent dans la région 24 sous la grille Gp1.

De l'autre côté de la grille P1, ou bien immédiatement adjacente à la grille Gp1 s'il n'y a pas de grille P1, on trouve la grille de stockage intermédiaire G1 surplombant une région de stockage intermédiaire 26 du substrat.

Enfin, adjacente à la grille G1, on trouve une grille d'évacuation Ge dont le potentiel est normalement bas mais qui est portée à un potentiel largement plus élevé que celui de la grille G1 à la fin de chaque cycle de lecture pour évacuer vers le drain DR1 les charges stockées sous la grille G1 lorsqu'on n'en a plus besoin. Le drain DR1 est une région de type N diffusée dans le substrat et portée à un potentiel positif supérieur à celui de la grille G1 au moment de l'évacuation.

Les diagrammes de potentiel représentés sur la figure 3 en correspondance avec les différentes régions semiconductrices montrent

- d'une part le transfert de la charge Qs de la diode D1 vers la région de stockage intermédiaire 26 sous la grille G1 pendant la phase F1a (et bien entendu aussi pendant les phases correspondantes F2a, F3a, etc., des étapes successives du cycle de lecture.

- d'autre part la restitution des charges de la région de stockage intermédiaire 26 vers la diode D1 pendant la phase F1c (et les phases F2c, F3c, etc., des autres étapes du cycle).

On peut voir sur la figure 3 que si le transfert de la diode D1 présente une certaine inefficacité ou un certain bruit, c'est-à-dire si une partie Qb (en positif ou en négatif)) de la charge utile Qs n'est pas transférée pendant la phase F1a, cette partie reste sur la diode et permet la reconstitution intégrale de la charge Qs sur la diode lorsque la partie Qs-Qb est retransférée à la phase F1c vers la diode D1. Cette reconstitution est totale car le transfert de la région 26 vers la diode D1 se fait avec un bruit négligeable et une efficacité voisine de 100 pour cent; il faut savoir en effet que le transfert de charges d'une diode vers une région sous une grille est affecté par un bruit important mais que le transfert inverse d'une région située sous une grille vers une diode n'est pratiquement pas affecté par du bruit.

Une des raisons pour laquelle l'invention peut fonctionner efficacement provient donc de la remarque que le bruit de transfert Qb varie aléatoirement au cours des différentes étapes F1a, F2a, F3a, etc., car il n'y a pas de corrélation entre les bruits engendrés lors des différents transferts, alors que la reconstitution de la charge Qs est à chaque fois exacte.

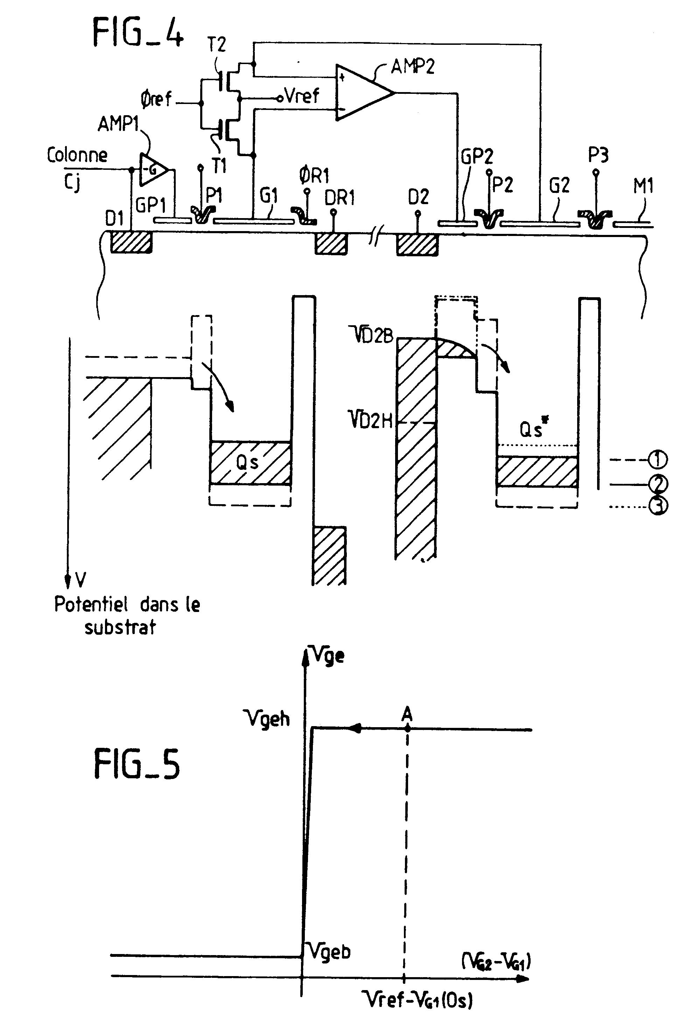

La figure 4 représente une coupe de la structure servant à la duplication de la charge Qs stockée sous la grille de stockage intermédiaire G1, avec, en correspondance avec les différentes régions semiconductrices de cette structure, les profils de potentiel successifs existant pendant l'opération de duplication.

Le duplicateur comporte essentiellement un comparateur AMP2 dont une première entrée est reliée à la grille G1 sous laquelle est stockée la charge Qs (affectée d'un bruit de transfert), et dont une deuxième entrée est connectée à une grille G2 sous laquelle doit être générée la charge réplique Qs∗.

La charge réplique Qs∗ est engendrée par un injecteur de charges similaire à l'injecteur connecté à la colonne Cj.

Cet injecteur comporte une diode d'entrée D2 (analogue à D1), une grille de passage Gp2 (analogue à Gp1), et éventuellement une grille auxiliaire P2 (analogue à P1).

Du point de vue des géométries des structures, des épaisseurs d'isolant de grille, des dopages de semiconducteur, l'ensemble D2, Gp2, P2, G2, est rigoureusement identique à l'ensemble D1, Gp1, P1, G1, pour obtenir une parfaite symétrie des organes connectés aux deux entrées du comparateur AMP2. On pourrait aussi envisager que les géométries des grilles G1 et G2 soient dans un rapport donné pour aboutir à une charge réplique Qs∗ dans un rapport connu différent de 1 avec Qs.

Les entrées du comparateur sont par ailleurs connectées chacune à la source d'un transistor MOS respectif, T1 pour la première entrée, T2 pour la deuxième, ces transistors jouant le rôle d'interrupteurs et ayant leurs drains reliés à un potentiel de référence Vref et leurs grilles connectées à une borne de commande qui permet de bloquer les transistors pendant un intervalle de temps correspondant à la phase de duplication de charges. Les transistors sont rendus conducteurs avant le début de cet intervalle.

Enfin, une grille de passage P3 adjacente à la grille G2 permet d'assurer le transfert de la charge réplique Qs∗ depuis la région située sous la grille G2 jusqu'à la région située sous la grille M1 mentionnée en référence à la figure 1.

La duplication de la charge Qs se fait de la manière suivante, illustrée par les niveaux de potentiels représentés respectivement en traits tiretés (au départ), en traits pleins (pendant la phase de transfert F1a ou F2a, etc. de la diode D1 vers la grille G1), et en traits pointillés (pendant la phase de duplication proprement dite F1b, F1c, etc.).

1. Départ (traits tiretés)

La grille P1 est à un niveau bas, ce qui retient la charge Qs sur la colonne; le potentiel Vref est appliqué sur les deux entrées du comparateur; ce dernier est conçu pour présenter une caractéristique comme celle de la figure 5, c'est-à-dire qu'il possède deux états stables et fournit un potentiel bas Vgeb lorsque la tension différentielle entre ses entrées est négative ou nulle, et un potentiel haut Vgeh lorsque la tension différentielle d'entrée est positive. La transition entre ces deux états est aussi raide que possible.

Au départ, la tension différentielle est nulle et le niveau de sortie du comparateur est donc Vgeb. Par ailleurs, la cathode de la diode D2 est portée à un niveau haut Vd2h; il n'y a donc pas d'injection de charges sous la grille G2.

## 2. Transfert de Qs (traits pleins)

Les transistors T1 et T2 sont bloqués et les grilles G1 et G2 deviennent flottantes; dans le même temps, la grille P1 est portée à un niveau haut, ce qui permet le transfert de Qs sous la grille G1; par symétrie, on applique de préférence en même temps un potentiel identique sur la grille homologue P2; le potentiel de la grille G1 diminue au fur et à mesure que des charges s'accumulent sous cette grille; très rapidement, le comparateur bascule et sa sortie passe au niveau haut Vgeh.

## 3. Génération de Qs* (traits pointillés)

Le potentiel de la diode D2 est alors porté à un niveau bas Vd2b, ce qui autorise l'injection de charges sous la grille G2; au fur et à mesure de cette injection, le potentiel de la grille G2 diminue; lorsque le potentiel de G2 atteint celui de G1, le comparateur rebascule et bloque (par la grille Gp2) tout transfert supplémentaire de charges de la diode D2 vers la grille G2.

La charge Qs* alors présente sous la grille G2 est la même que la charge Qs sous la grille G1 pour les raisons de symétrie indiquées plus haut.

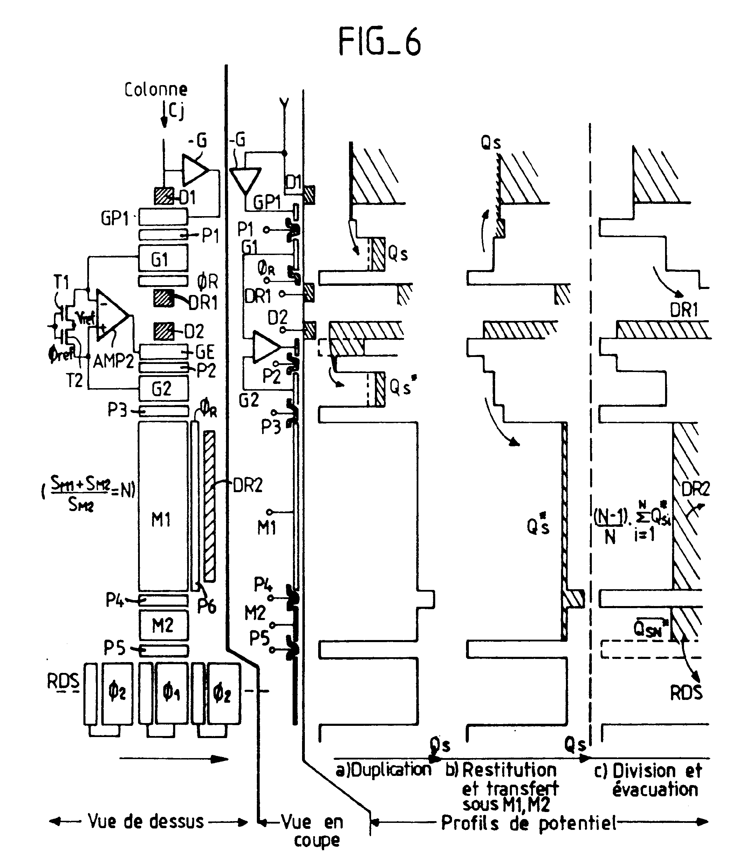

La figure 6 représente l'ensemble de la structure permettant de mettre en oeuvre l'invention, en vue de dessus et en coupe transversale, et avec en outre les profils de potentiel dans les différentes régions semiconductrices pendant les principales phases de fonctionnement.

On ne redécrira pas les éléments déjà décrits, à savoir l'injecteur de charges en sortie de la colonne Cj, et le duplicateur de charges. Ces éléments portent les mêmes références qu'aux figures précédentes.

D'un côté de la grille P3 on retrouve la grille G2; de l'autre côté, on trouve une grille M1 qu'on peut appeler grille d'accumulation car c'est sous cette grille M1 qu'on veut accumuler les charges répliques Qs* engendrées sous la grille G2 pendant les étapes successives de duplication F1b, F2b, etc.

De l'autre côté de la grille M1, on trouve une grille de blocage P4 et, de l'autre côté de cette grille P4, une grille M2 qui est en permanence portée au même potentiel que la grille M1; la grille M2 participe à l'accumulation de charges tant que la grille de blocage P4 est à un potentiel plus haut que celui des métallisations M1 et M2, et les charges transférées de la grille G2 vers la grille M1 se répartissent en fait entre les grilles M1 et M2 en proportion de leurs surfaces respectives. Au contraire, lorsque l'accumulation de charges est terminée à la fin de la N$^{ième}$ étape, la grille de blocage P4 est portée à un potentiel bas (immédiatement avant le début de la phase Fnd de la figure 1) et les charges stockées sous la grille M2 sont alors isolées des charges stockées sous la grille M1; une fraction de l'accumulation de charges subsiste sous la grille M2 et le reste sous la grille M1. C'est cette fraction stockée sous la grille M2, par exemple N fois plus faible que la totalité des charges accumulées sous les deux grilles M1 et M2, qui peut être transférée vers le registre à décalage de sortie RDS à travers une grille de passage P5 ouverte pendant la phase Fnd.

La structure comporte enfin, proche de la métallisation M1 et séparée d'elle par une grille de passage P6, le drain DR2 déjà mentionné à propos de la figure 2; cette grille de passage est ouverte pendant une phase finale Fne pour évacuer les charges subsistant sous la grille M1 à la fin du cycle de lecture.

Dans tout ce qui précède il n'a pas été fait mention de la possibilité de transférer avec la charge Qs, vers la sortie, une charge dite "d'entraînement" ayant pour fonction d'assurer qu'un minimum de charges est physiquement transmis même lorsque la charge Qs utile est très faible. Cela permet de faciliter la lecture des faibles charges, pourvu que la charge d'entraînement soit bien constante d'une mesure à l'autre. Un procédé de lecture avec charge d'entraînement est décrit dans le brevet US 4,611,234.

Si on utilise une charge d'entraînement, cette charge est alors dupliquée en même temps que la charge utile Qs. On la retrouve multipliée par N dans la somme de charges accumulées sous les grilles M1 et M2, et on la retrouve encore dans la moyenne transférée de la grille M2 vers la sortie du circuit.

Comme le registre de sortie RDS n'est plus en liaison directe avec la grille G1 et la colonne, on ne peut plus assurer la remontée vers l'amont de la charge d'entraînement depuis ce registre vers la colonne; cela a pour conséquence qu'on ne peut plus introduire la charge d'entraînement à partir du registre de sortie.

Dans la présente invention, on propose d'introduire la charge d'entraînement à partir d'un registre auxiliaire situé non pas du même côté que le registre de sortie mais de l'autre côté de la matrice photosensible elle-même (c'est-à-dire à l'autre extrémité des colonnes de celle-ci).

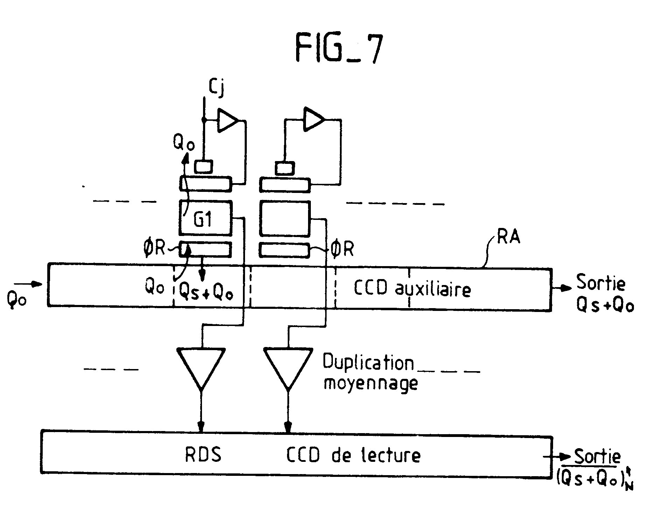

Dans une autre réalisation, représentée schématiquement à la figure 7, on remplace le drain d'évacuation DR1 adjacent à la grille G1 (figure 1) par une case d'un registre à transfert de charges auxiliaire RA, séparé de la grille G1 par une grille de transfert de la même manière que le drain DR1 était séparé de la grille G1. Ce registre transporte en permanence d'une extrémité à l'autre une charge égale à la charge d'entraînement désirée; cette charge Q0 est injectée à une extrémité du registre. La charge Q0 est injectée du registre sous la grille G1 et de la grille G1 vers la colonne Cj à chaque phase de restitution F1c, F2c, etc.

Dans le cas où la capacité de la colonne est très élevée, la charge d'entraînement devient d'amplitude trop importante; il faut la réduire par passages successifs avec réduction d'amplitude dans des sites de transfert intermédiaires, jusqu'à ce que son amplitude soit acceptable. Une méthode pour le faire est décrite dans le brevet français FR-A-2 608 340. C'est ensuite seulement qu'on procède aux opérations de duplication et moyennage.

Pour terminer, il faut signaler qu'il est particulièrement avantageux que les transferts de charge se fassent en volume et non en surface, comme décrit dans le brevet français FR-A-2 551 919, c'est-à-dire que le dopage du substrat semiconducteur est tel que les bandes de conduction à l'intérieur du substrat présentent un minimum à l'intérieur du volume (à proximité de la surface), mais non à la surface elle-même.

## Revendications

1. Procédé de lecture des charges électriques recueillies sur un conducteur d'entrée (Cj), comprenant une opération de transfert de charges du conducteur d'entrée vers une zone (26) de stockage intermédiaire, cette opération étant répétée N fois avec N entier supérieur ou égal à deux, et une opération de transfert vers une sortie d'une quantité de charges proportionnelle à la somme des charges transférées au cours des N opérations de transfert précédentes, caractérisé en ce que chaque opération de transfert d'une quantité de charges Qs du conducteur d'entrée vers la zone de stockage intermédiaire (26) est suivie d'une opération de duplication de charges par laquelle on constitue une charge Qs∗ réplique de la charge Qs, la charge réplique étant dans un rapport prédéterminé avec la charge Qs, puis d'une opération de restitution de la charge Qs vers le conducteur d'entrée.

2. Procédé de lecture selon la revendication 1, caractérisé en ce que chaque opération dle duplication est suivie d'une opération d'accumulation par laquelle on accumule les charges répliques constituées au cours des opérations de duplication successives.

3. Circuit de lecture de charges connecté à un conducteur d'entrée amenant des charges à lire, ce circuit comportant :
   - un moyen (D1, GP1, G1, AMP1) pour transférer du conducteur d'entrée vers une zone de stockage intermédiaire (26) une quantité de charges (Qs) à lire,
   - un moyen pour répéter les opérations de transfert de l' entrée vers la zone intermédiaire,
   caractérisé en ce qu'il comporte en outre :
   - un moyen (AMP2, T1, T2, D2, G2) pour engendrer une quantité de charges (Qs∗) qui est la réplique de la charge transférée dans la zone de stockage intermédiaire,
   - un moyen (G1) pour retransférer vers le conducteur d'entrée la quantité de charges (Qs) transférée du conducteur d'entrée,
   - un moyen (M1, M2) pour stocker une charge qui est la somme des charges répliques,
   - et un moyen (M2, P4, P5) pour transférer vers la sortie une charge proportionnelle à la somme des charges répliques.

4. Circuit de lecture selon la revendication 3, caractérisé en ce que le moyen pour transférer les charges du conducteur d'entrée (Cj) vers la zone de stockage intermédiaire est un injecteur de charges comprenant une diode (D1) reliée au conducteur d'entrée, une grille de passage (GP1) entre la diode et la zone de stockage intermédiaire, une grille de stockage intermédiaire (G1) au dessus de la zone de stockage intermédiaire, et un amplificateur (AMP1) à gain négatif ayant une entrée reliée au conducteur d'entrée et une sortie reliée à la grille de passage (GP1).

5. Circuit de lecture selon la revendication 4, caractérisé en ce que le moyen pour engendrer la quantité de charges réplique (Qs∗) comprend d'une part un deuxième injecteur semblable au premier, comprenant une diode (D2), une grille de passage (GP2), une grille de stockage auxiliaire (G2) au dessus d'une zone de stockage auxiliaire, d'autre part un comparateur (AMP2) ayant une première entrée reliée à la grille de stockage intermédiaire (G1), une deuxième entrée reliée à la grille de stockage auxiliaire (G2), et une sortie reliée à la grille de passage du deuxième injecteur, et enfin un moyen (T1, T2) pour appliquer temporairement que les deux entrées du comparateur une tension de référence (Vref) commune.

6. Circuit de lecture selon l'une des revendications 3 à 5, caractérisé en ce que le moyen pour stocker la somme des charges répliques comprend deux grilles de stockage (M1, M2) portées au même potentiel, séparées l'une de l'autre par une grille de passage (P4) portée à un potentiel supérieur à ce potentiel.

7. Circuit de lecture selon la revendication 6, caractérisé en ce que le moyen pour transférer vers la sortie une charge proportionnelle à la somme des charges répliques comprend un moyen de commande de la grille de passage (P4) située entre les deux grilles de stockage du moyen de stockage de la somme des charges répliques, pour abaisser fortement le potentiel de cette grille de passage, et un moyen pour abaisser ensuite le potentiel de l'une de ces deux grilles (M1, M2) de stockage.

8. Circuit de lecture selon l'une des revendications 3 à 7, caractérisé en ce que son entrée est reliée à un conducteur de colonne d'une matrice photosensible.

9. Circuit de lecture pour matrice photosensible à transfert de ligne, caractérisé en ce qu'il comporte plusieurs circuits selon l'une des revendications 3 à 8, chacun relié à une colonne de la matrice.

**Patentansprüche**

1. Leseverfahren für elektrische Ladungen, die auf einem Eingangsleiter (Cj) liegen, mit einer Ladungstransferoperation vom Eingangsleiter zu einer Zwischenspeicherzone (26), wobei diese Operation N mal wiederholt wird und N eine ganze Zahl $\geq 2$ ist, und mit einer Operation der Übertragung einer Ladungsmenge zu einem Ausgang, die proportional zur Summe der während der N vorhergehenden Transferoperationen übertragenen Ladungen ist, dadurch gekennzeichnet, daß jede Transferoperation einer Ladungsmenge Qs vom Eingangsleiter auf die Zwischenspeicherzone (26) von einer Ladungsduplikationsoperation gefolgt wird, in der eine Replikladung Qs* der Ladung Qs gebildet wird, die in einem vorgegebenen Verhältnis zur Ladung Qs steht, worauf eine Operation folgt, in der die Ladung Qs zum Eingangsleiter zurückgeführt wird.

2. Leseverfahren nach Anspruch 1, dadurch gekennzeichnet, daß jede Duplikationsoperation von einer Akkumulationsoperation gefolgt wird, in der die Replikladungen akkumuliert werden, die während der aufeinanderfolgenden Duplikationsoperationen gebildet wurden.

3. Ladungsleseschaltung, die an einen Eingangsleiter angeschlossen ist, der zu lesende Ladungen liefert, wobei die Schaltung aufweist:
    - ein Mittel (D1, GP1, G1, AMP1), um vom Eingangsleiter eine zu lesende Ladungsmenge (Qs) in eine Zwischenspeicherzone (26) zu übertragen,
    - ein Mittel, um die Transferoperationen vom Eingang zur Zwischenzone zu wiederholen, dadurch gekennzeichnet, daß die Schaltung außerdem aufweist
    - ein Mittel (AMP2, T1, T2, D2, G2,), um eine Ladungsmenge (Qs*) zu bilden, die die Replik der in die Zwischenspeicherzone übertragenen Ladung ist,
    - ein Mittel (G1), um die Ladungsmenge (Qs) die vom Eingangsleiter übertragen wurde, zum Eingangsleiter zurückzuübertragen,
    - ein Mittel (M1, M2), um eine Ladung zu speichern, die die Summe der Replikladungen ist,

- und ein Mittel (M2, P4, P5), um an den Ausgang eine Ladung zu übertragen, die proportional zur Summe der Replikladungen ist.

4. Leseschaltung nach Anspruch 3, dadurch gekennzeichnet, daß das Mittel, um die Ladungen vom Eingangsleiter (Cj) zur Zwischenspeicherzone zu übertragen, ein Ladungsinjektor ist, der eine an den Eingangsleiter angeschlossene Diode (D1), ein Durchgangsgate (GP1) zwischen der Diode und der Zwischenspeicherzone, ein Zwischenspeichergate (G1) oberhalb der Zwischenspeicherzone und einen Verstärker (AMP1) mit negativem Verstärkungsgrad aufweist, dessen Eingang an den Eingangsleiter und dessen Ausgang an das Durchgangsgate (GP1) angeschlossen ist.

5. Leseschaltung nach Anspruch 4, dadurch gekennzeichnet, daß das Mittel, um die Replikladungsmenge (Qs*) zu erzeugen, einerseits einen zweiten dem ersten Injektor ähnlenden Injektor mit einer Diode (D2), einem Durchgangsgate (GP2), einem Hilfsspeichergate (G2) oberhalb einer Hilfsspeicherzone und andererseits einen Komparator (AMP2) aufweist, dessen erster Eingang an das Zwischenspeichergate (G1), dessen zweiter Eingang an das Hilfsspeichergate (G2) und dessen Ausgang an das Durchgangsgate des zweiten Injektors angeschlossen ist und daß weiter ein Mittel (T1, T2) vorgesehen ist, um vorübergehend an die beiden Eingänge des Komparators eine gemeinsame Bezugsspannung (Vref) anzulegen.

6. Leseschaltung nach einem der Ansprüche 3 bis 5, dadurch gekennzeichnet, daß das Mittel zum Speichern der Summe der Replikladungen zwei Speichergates (M1, M2) aufweist, die auf demselben Potential liegen und gegeneinander durch ein Durchgangsgate (P4) getrennt sind, das auf ein höheres Potential als dieses Potential gelegt ist.

7. Leseschaltung nach Anspruch 6 dadurch gekennzeichnet, daß das Mittel, um zum Ausgang einem der Summe der Replikladungen proportionale Ladung übertragen, ein Mittel zur Steuerung des Durchgangsgates (P4), das zwischen den beiden Speichergates des Mittels zur Speicherung der Replikladungssumme liegt, um das Potential diese Durchgangsgates stark abzusenken, und ein Mittel aufweist, um dann das Potential eines dieser beiden Speichergates (M1, M2) abzusenken.

8. Lesekreis nach einem der Ansprüche 3 bis 7 dadurch gekennzeichnet, daß sein Eingang an einen Spaltenleiter einer lichtempfindlichen Matrix angelegt ist.

9.  Leseschaltung für eine lichtempfindliche Matrix mit Zeilentransfer, dadurch gekennzeichnet, daß sie mehrere Schaltungen nach einem der Ansprüche 3 bis 8 aufweist, die je an eine Spalte der Matrix angeschlossen sind.

**Claims**

1.  A method for reading electric charges collected from an input conductor (Cj), comprising an operation of transferring charges from the input conductor to an intermediate storage zone (26), said operation being repeated N times, N being an integer $\geqq 2$, and an operation of transferring towards an output a quantity of charges proportional to the sum of the charges transferred during the N preceding transfer operations, characterized in that each operation of transferring a quantity of charges Qs from the input conductor to the intermediate storage zone (26) is followed by a charge duplication operation in which an image charge Qs* with respect to the charge Qs is formed, the image charge being correlated to the charge Qs by a predetermined ratio, then by a restitution operation in which the charge Qs is restituted to the input conductor.

2.  A method according to claim 1, characterized in that each duplication operation is followed by an accumulation operation in which the image charges formed during the successive duplication operations are accumulated.

3.  A circuit for reading charges which is connected to an input conductor supplying charges to be read and comprises:
    - a means (D1, GP1, G1, AMP1) for transferring a quantity of charges (Qs) to be read from the input conductor to an intermediate storage zone (26),
    - a means for repeating the transfer operations from the input to the intermediate zone, characterized in that the circuit further comprises
    - a means (AMP2, T1, T2, D2, G2) for producing a quantity of charges (Qs*) which is an image of the charge transferred to the intermediate storage zone,
    - a means (G1) for retransferring towards the input conductor the quantity of charges (Qs) transferred from the input conductor,
    - a means (M1, M2) for storing a charge which is the sum of the image charges,
    - and a means (M2, P4, P5) for transferring towards the output a charge which is proportional to the sum of the image charges.

4.  A circuit according to claim 3, characterized in that the means for transferring the charges from the input conductor (Cj) to the intermediate storage zone is constituted by a charge injector comprising a diode (DI) connected to the input conductor, a passage gate (GP1) between the diode and the intermediate storage zone, an intermediate storage gate (G1) above the intermediate storage zone and an amplifier (AMP1) with negative gain having an input connected to the input conductor and an output connected to the passage gate (GP1).

5.  A circuit according to claim 4, characterized in that the means for forming the image charge quantity (Qs*) comprises on the one hand a second injector similar to the first one and including a diode (D2), a passage gate (GP2), an auxiliary storage gate (G2) above an auxiliary storage zone, and on the other hand a comparator (AMP2) having a first input connected to the intermediate storage gate (G1), a second input connected to the auxiliary storage gate (G2) and an output connected to the passage gate of the second injector, and finally a means (T1, T2) for temporarily applying a common reference voltage (Vref) to the two inputs of the comparator.

6.  A circuit according to one of claims 3 to 5, characterized in that the means for storing the sum of the image charges comprises two storage gates (M1, M2) fed with the same potential and mutually separated by a passage gate (P4), to which a higher potential than the first-mentioned potential is applied.

7.  A circuit according to claim 6, characterized in that the means for transferring a charge which is proportional to the sum of the image charges towards the output comprises a means for controlling the passage gate (P4) situated between the two storage gates of the means for storing the sum of the image charges, in order to considerably lower the potential of this passage grid, and a means for subsequently lowering the potential of one of said two storage gates (M1, M2).

8.  A circuit according to one of claims 3 to 7, characterized in that its input is connected to a column conductor of a photosensitive matrix.

9.  A read-out circuit for a photosensitive line transfer matrix, characterized in that it comprises a plurality of circuits according to one of claims 3 to 8, each one connected to a respective column of the matrix.

## FIG_1

REGISTRE
D'ADRESSAGE
LIGNE

12

10

Pij

Li

Cj

Colonnes
de lecture

CL

RDS → S

## FIG_2

Cj Colonne de lecture

F1c
F1a Qs
F2c
Fna
F2a

D1
GP1
AMP1 ← G

G1
(drain)
DR1
Fnc Evacuation

AMP2

Duplication ⓟF1b) F2b···

$Q_s^d$

Sommation
$\Sigma Q_s^d$
DR2

Moyennage
M1
Fne

Division
Fnd

$\dfrac{\Sigma Q_s^d}{N}$

RDS
Transfert au registre $Q_s$
de sortie

Registre à transfert
de charge

## FIG_3

AMP1

Colonne
Cj

G

GP1 P1

D1

G1 Ge

20 22 24 F1a 26 DR1

$Q_b$ F1a

$Q_s - Q_b$

F1c

$Q_s$

**FIG_4**

Potentiel dans le
substrat

**FIG_5**

# FIG_6

Colonne Cj

-G

-G

Y

D1

GP1

P1

G1

T1

Vref

ØR

DR1

D2

GE

AMP2

P2

T2

G2

P3

ØR

$(\frac{S_{M1}+S_{M2}}{S_{M2}}=N)$

M1

DR2

P4

P6

M2

P5

RDS

Φ2  Φ1  Φ2

GP1

P1

G1

ØR

DR1

D2

P2

G2

P3

M1

P4

M2

P5

D1

Qs

Qs"

Qs

Qs

a) Duplication

Qs

Q"s

b) Restitution
et transfert
sous M1, M2

Qs

DR1

DR2

$\frac{(N-1)}{N}.\sum_{i=1}^{N}Q_{si}^{\#}$

$\overline{Q_{SN}^{\#}}$

RDS

c) Division et
évacuation

← Vue de dessus → ← Vue en coupe → Profils de potentiel →

# FIG_7